(19) Europäisches Patentamt
European Patent Office
Office européen des brevets

(11) Publication number: **0 270 672 B1**

# (12) EUROPEAN PATENT SPECIFICATION

(45) Date of publication of patent specification: **01.06.94**

(51) Int. Cl.5: **H05K 1/03**, B32B 15/08, C08G 73/10

(21) Application number: **86904358.8**

(22) Date of filing: **30.06.86**

(86) International application number: **PCT/JP86/00334**

(87) International publication number: **WO 88/00428 (14.01.88 88/02)**

## (54) FLEXIBLE COPPER-CLAD CIRCUIT BOARD.

(43) Date of publication of application: **15.06.88 Bulletin 88/24**

(45) Publication of the grant of the patent: **01.06.94 Bulletin 94/22**

(84) Designated Contracting States: **CH DE FR GB IT LI NL**

(56) References cited:

| | |
|---|---|
| EP-A- 0 048 221 | EP-A- 0 089 387 |
| JP-A- 5 235 281 | JP-A-58 155 790 |
| JP-A-58 190 092 | JP-A-60 243 120 |
| JP-A-60 258 228 | US-A- 4 411 952 |

(73) Proprietor: **MITSUI TOATSU CHEMICALS, Inc.**
**2-5 Kasumigaseki 3-chome**
**Chiyoda-Ku Tokyo 100(JP)**

(72) Inventor: **OHTA, Masahiro**
**1541, Yabe-cho**
**Totsuka-ku**
**Yokohama-shi Kanagawa-ken 244(JP)**
Inventor: **KAWASHIMA, Saburo**
**4-37-14, Oyabe**
**Yokosuka-shi Kanagawa-ken 238(JP)**
Inventor: **SONOBE, Yoshiho**
**2070, Iijima-cho**
**Totsuka-ku**
**Yokohama-shi Kanagawa-ken 244(JP)**
Inventor: **TAMAI, Shoji**
**2070, Iijima-cho**
**Totsuka-ku**
**Yokohama-shi Kanagawa-ken 244(JP)**
Inventor: **OIKAWA, Hideaki**
**2070, Iijima-cho**
**Totsuka-ku**
**Yokohama-shi Kanagawa-ken 244(JP)**
Inventor: **YAMAGUCHI, Akihiro**
**1-13-14, Zaimokuza**
**Kamakura-shi Kanagawa-ken 248(JP)**

(74) Representative: **Hayward, Denis Edward Peter et al**
**Lloyd Wise, Tregear & Co.**
**Norman House**
**105-109 Strand**
**London WC2R 0AE (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.09/3.3.3)

## Description

The present invention relates to flexible copper-clad circuit substrates and more particularly to flexible copper-clad circuit substrates which are excellent in high-temperature stability and high-temperature adhesion and to processes for their preparation.

The flexible copper-clad circuit substrates which are used for printed circuit substrates of electronic instruments recently have had a serious problem of increase in heat generation accompanied by increase in package density and wiring pattern density. Thus an important concern is to improve the high-temperature stability of the substrates. High-temperature resins which can substitute for conventional expoxy resin include heat-stable epoxy, polyamide imide, polybenzimidazole, silicone, and polyimide resins. These resins, however, are not always satisfactory in regard to peel strength on copper foil. Among these resins, polyimide in particular is excellent in high-temperature stability and electrical characteristics, and has increasingly been of interest as a material for electrical insulation. Polyimide, however, has poor bonding strength to metals and requires adhesives to bond the copper foil when polyimide is used for the base film of copper-clad circuit substrates. In spite of the good high-temperature stability of polyimide, insufficient thermal stability of the adhesives prevents the full utilization of that high-temperature stability. Therefore, a polyimide is very desirable which not only has excellent high-temperature stability but also adhesive strength in bonding to metals.

An object of this invention is to provide a high-temperature stable and flexible copper-clad circuit substrate which shows no reduction of adhesive strength during and after use at high temperatures and requires no adhesives.

United States Patent No. 4,416,952 describes a form of polyimide using 4,4'-diaminobenzophenone as the diamine component, which can be directly bonded to a copper foil without an adhesive.

The inventors researched intensively to solve the problem and have, however, discovered that polyimide prepared from a particular diamine and tetracarboxylic acid dianhydride is flowable at high temperatures and also excellent in high temperature stability and bonding strength to a copper foil.

Accordingly, the present invention provides a flexible copper-clad circuit substrate which comprises a high-temperature flowable polyimide film faced with copper foil bonded directly thereto, without adhesive in between, wherein the polyimide film essentially consists of a polyimide having recurring units of the formula:

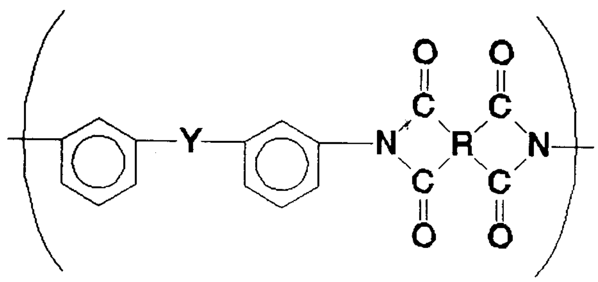

where R represents an aliphatic radical having 2 or more carbons, a cycloaliphatic radical, a monocyclic aromatic radical, a condensed polyaromatic radical, or a non-condensed polyaromatic radical in which the aromatic rings are connected directly or by a bridging member, and Y represents:

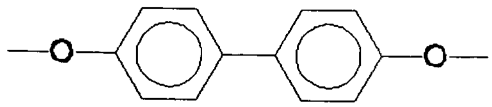

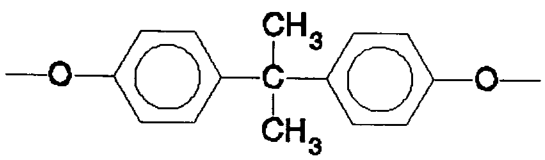

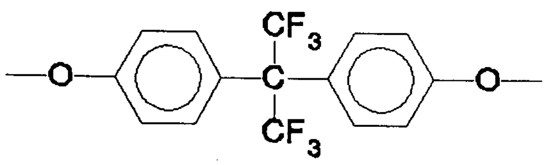

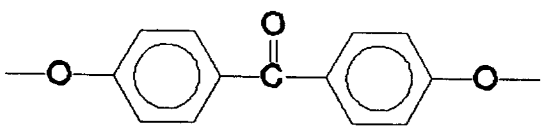

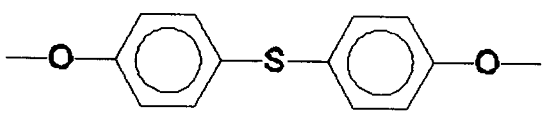

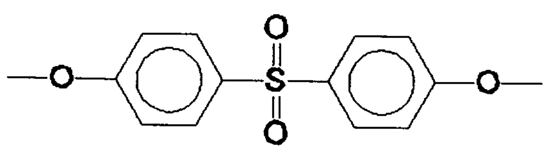

or

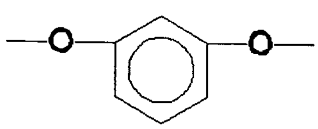

The invention also extends to a process for making a process for making a flexible copper-clad circuit substrate which comprises a high-temperature flowable polyimide film faced with copper foil bonded directly thereto, without adhesive in between, wherein the polyimide film essentially consists of a polyimide having recurring units of the formula:

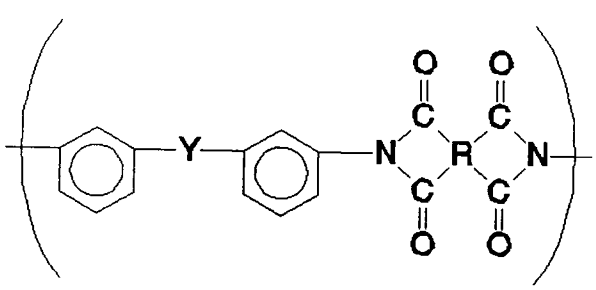

where R represents an aliphatic radical having 2 or more carbons, a cycloaliphatic radical, a monocyclic aromatic radical, a condensed polyaromatic radical, or a non-condensed polyaromatic radical in which the aromatic rings are connected directly or by a bridging member, and Y represents:

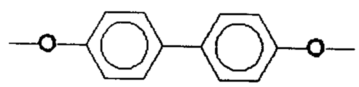

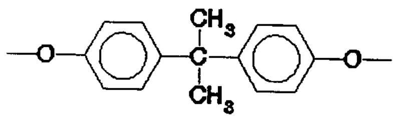

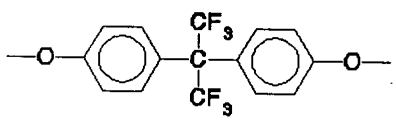

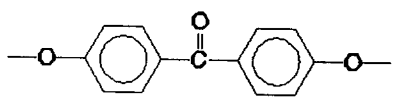

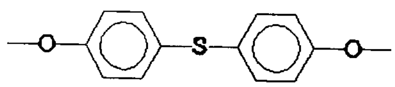

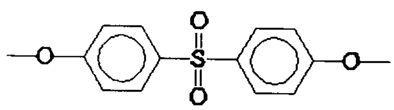

or

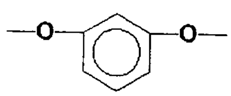

,

and in that a film or powder of the polyimide is placed on the copper foil, the film or powder is pressed at 50 to 400 ° C under a pressure of 1 to 1,000kg/cm$^2$ and the resulting pressed film is curing at a temperature of 100 to 400 ° C.

The invention further extends to a process for making a process for making a flexible copper-clad circuit substrate which comprises a high-temperature flowable polyimide film faced with copper foil bonded directly thereto, without adhesive in between, wherein the polyimide film essentially consists of a polyimide having recurring units of the formula:

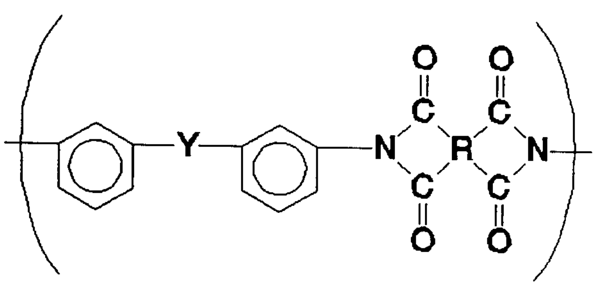

where R represents an aliphatic radical having 2 or more carbons, a cycloaliphatic radical, a monocyclic aromatic radical, a condensed polyaromatic radical, or a non-condensed polyaromatic radical in which the

aromatic rings are connected directly or by a bridging member, and Y represents:

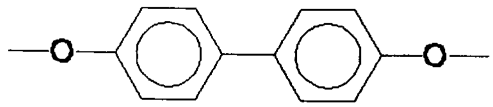

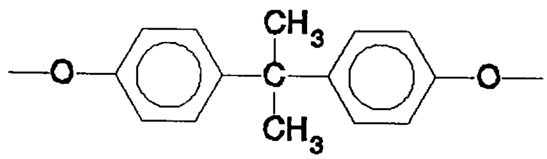

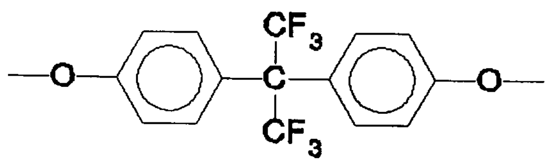

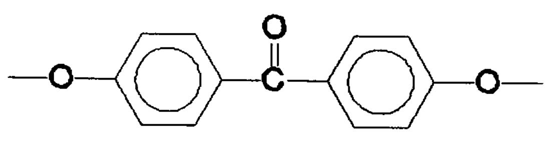

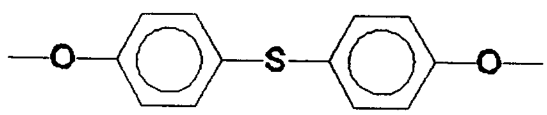

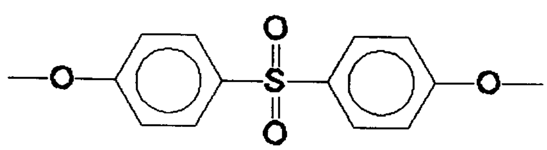

or

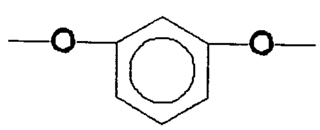

,

and in that a solution of the polyamic acid precursor for the said polyimide is placed on the copper foil, the polyamic acid solution having a viscosity of 1,000 to 300,000 centipoises, and heating the polyamic acid solution at 100 to 400 °C to remove the solvent and convert the polyamic acid to the said polyimide.

By high temperature flowable polyimide is meant polyimide which has a melt viscosity of 5 x $10^5$ poises or less at 400 °C and a shear rate of $10^3$ l/second determined by the flow tester according to the Society of Polymer Science model (Shimadzu Seisakusho CFT-500) with a nozzle of 0.1 cm in diameter and 1 cm in length. Polyimides in this category are prepared from the following diamines and tetracarboxylic acid dianhydrides.

The polyimide and/or its polyamic acid precursor for use in making the substrate of this invention are not restricted to the particular method of their preparation. They can normally be prepared by polymerizing various diamines with tetracarboxylic acid dianhydrides in organic solvents.

Diamines for use in this method are 1,3-bis(3-aminophenoxy)benzene, 4,4'-bis(3-aminophenoxy)-biphenyl, 2,2-bis[4-(3-aminophenoxy)phenyl]propane, 2,2-bis[4-(3-aminophenoxy)phenyl]-1,1,1,3,3,3,-hexafluoropropane, bis[4-(3-aminophenoxy)-phenyl] sulfide, bis[4-(3-aminophenoxy)phenyl] ketone and bis-[4-(3-aminophenoxy)phenyl] sulfone. These can be used singly or in mixtures of two or more.

The tetracarboxylic acid dianhydride to be reacted with the diamine has the following formula(I):

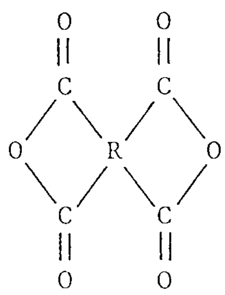

(I)

(where R is a tetra-valent radical selected from aliphatic radicals having 2 or more carbons, cycloaliphatic radicals, monocyclic aromatic radicals, fused polycyclic aromatic radicals, and polycyclic aromatic radicals wherein the aromatic rings are connected together by a direct bond or via a bridging group.)

Such dianhydrides include, for example, ethylene tetracarboxylic dianhydride, cyclopentane tetracarboxylic dianhydride, pyromellitic dianhydride, 3,3',4,4'-benzophenone tetracarboxylic dianhydride, 2,2',3,3'-benzophenone tetracarboxylic dianhydride, 3,3',4,4'-biphenyl tetracarboxylic dianhydride, 2,2'3,3'-biphenyl tetracarboxylic dianhydride, 2,2-bis(3,4-dicarboxyphenyl)propane dianhydride, 2,2-bis-(2,3-dicarboxyphenyl)-propane dianhydride, bis(3,4-dicarboxyphenyl) ether dianhydride, bis(3,4-dicarboxyphenyl) sulfone dianhydride, 1,1-bis(2,3-dicarboxyphenyl)ethane dianhydride, bis(2,3-dicarboxyphenyl)methane dianhydride, bis-(3,4-dicarboxyphenyl)methane dianhydride, 2,3,6,7-naphthalene tetracarboxylic dianhydride, 1,4,5,8-naphthalene tetracarboxylic dianhydride, 1,2,5,6-naphthalene tetracarboxylic dianhydride, 1,2,3,4-benzene tetracarboxylic dianhydride, 3,4,9,10-perilene tetracarboxylic dianhydride, 2,3,6,7-anthracene tetracarboxylic dianhydride and 1,2,7,8-phenanthrene tetracarboxylic dianhydride. These are used singly or in mixtures of two or more.

Particularly preferred tetracarboxylic acid dianhydrides are pyromellitic dianhydride, 3,3',4,4'-benzophenone tetracarboxylic dianhydride, 3,3',4,4'-biphenyl tetracarboxylic dianhydride and bis-(3,4-dicarboxyphenyl) ether dianhydride.

The polyamic acid precursor of the polyimide is normally prepared in an organic solvent.

Suitable organic solvents include, for example, N-methyl-2-pyrrolidone, N,N-dimethylacetamide, N,N-dimethylformamide, 1,3-dimethyl-2-imidazolidinone, N,N-diethylacetamide, N,N-dimethyl-methoxyacetamide, dimethyl sulfoxide, pyridine, dimethyl sulfone, hexamethylphosphoramide, tetramethylurea, N-methylcaprolactam, tetrahydrofuran, m-dioxane, p-dioxane, 1,2-dimethoxyethane, bis(2-methoxyethyl) ether, 1,2-bis(2-methoxyethoxy)ethane and bis(2-(2-methoxyethoxy)ethyl] ether. These solvents can be used singly or in mixtures of two or more.

The reaction temperature is normally 200 °C or less and preferably 50 °C or less. The reaction pressure is not particularly restricted and the reaction can satisfactorily be conducted at atmospheric pressure.

The reaction time depends upon the type of solvent, the reaction temperature, the diamine and the acid dianhydride used and is normally long enough to complete the formation of polyamic acid. Usually 4-24 hours is sufficient.

The corresponding polyimide can be obtained from the polyamic acid by imidizing thermally at 100-400 °C or by use of a dehydrating agent such as acetic anhydride.

For example, bis[4-(3-aminophenoxy)phenyl] sulfide is reacted in an organic solvent with tetracarboxylic acid dianhydride having the formula (I):

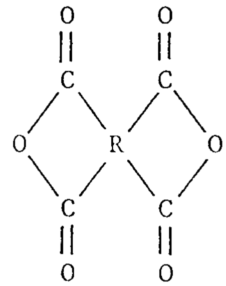

(I)

(where R is the same as before) to give a polyamic acid having recurring units of the formula (II):

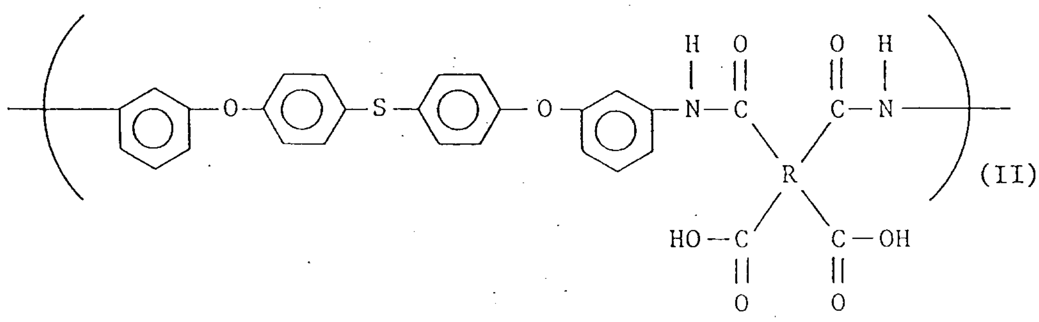

(II)

(where R is the same as before).

The polyamic acid thus obtained is imidized to give a polyimide having recurring units of the formula (III):

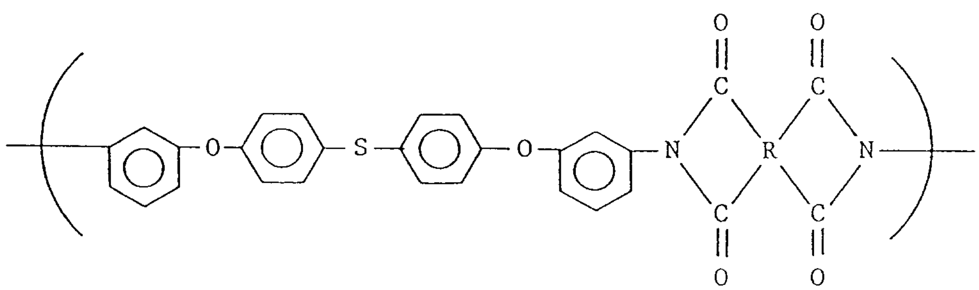

(III)

(where R is the same as before).

In the practice of the present invention, the following polyimides are preferably used in particular.

(1) Polyimides which are derived from 4,4'-bis(3-aminophenoxy)-biphenyl and a tetracarboxylic acid dianhydride having the formula (I):

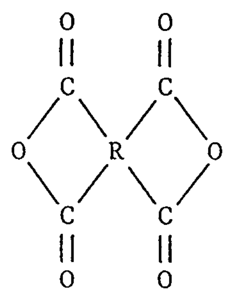

(I)

(where R is the same as before) and which have recurring units of the formula (IV)

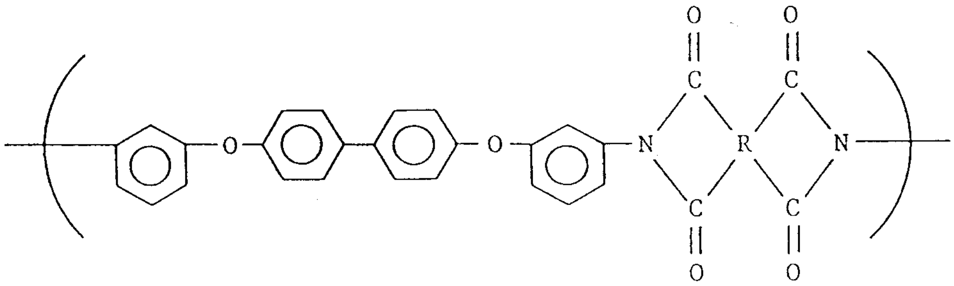

(IV)

(where R is the same as before).

(2) Polyimides which are derived from 2,2-bis[4-(3-aminophenoxy)-phenyl]propane and a tetracarboxylic acid dianhydride having the formula (I):

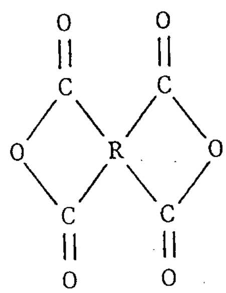

(I)

(where R is the same as before) and which have recurring units of the formula (V):

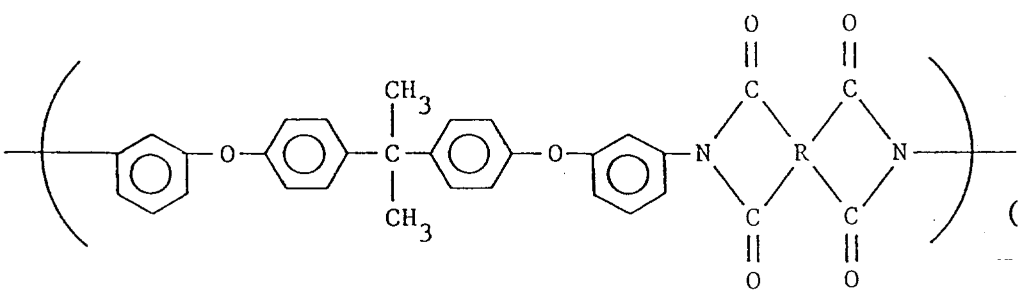

(V)

(where R is the same as before).

(3) Polyimides which are derived from 2,2-bis[4-(3-aminophenoxy)-phenyl]-1,1,1,3,3,3-hexafluoropropane and a tetracarboxylic acid dianhydride having the formula (I):

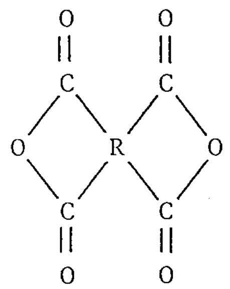

(I)

(where R is the same as before)
and which have recurring units of the formula (VI):

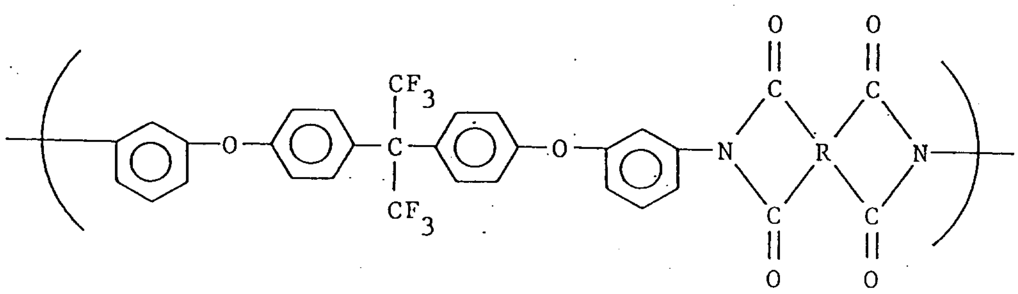

(VI)

(where R is the same as before).

(4) Polyimides which are derived from bis[4-(3-aminophenoxy)phenyl] ketone and a tetracarboxylic acid dianhydride having the formula (I):

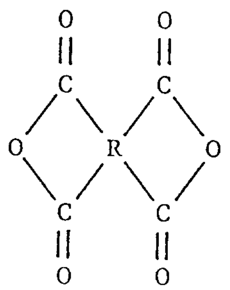

(I)

(where R is the same as before)
and which have recurring units of the formula (VII):

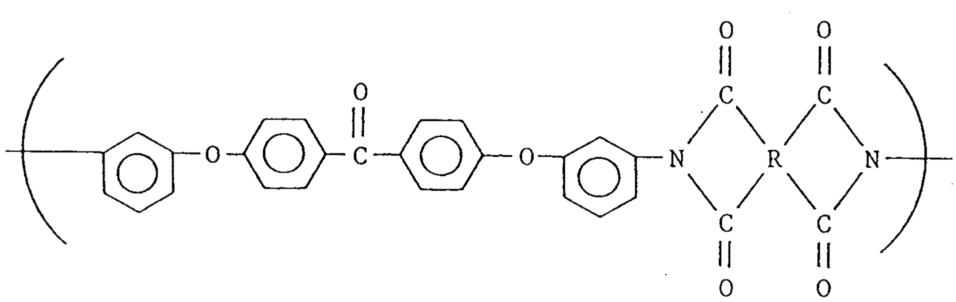

(VII)

(where R is the same as before).

(5) Polyimides which are derived from bis[4-(3-aminophenoxy)phenyl] sulfide and a tetracarboxylic acid dianhydride having the formula (I):

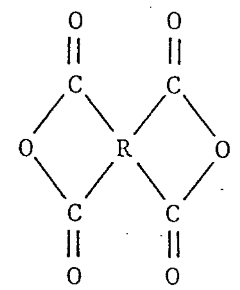

(I)

(where R is the same as before)
and which have recurring units of the formula (VIII):

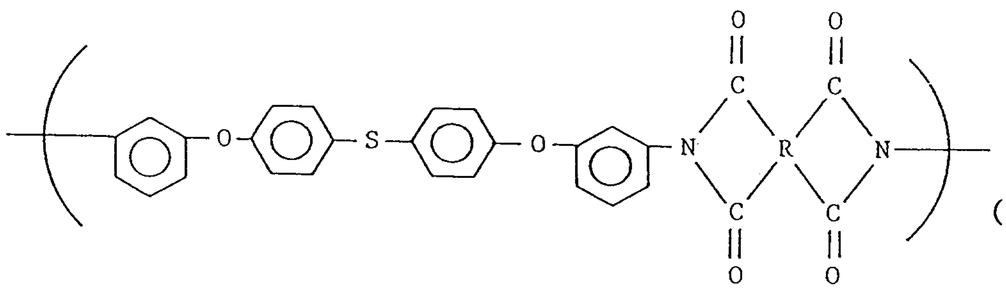

(VIII)

(where R is the same as before).
(6) Polyimides which are derived from bis[4-(3-aminophenoxy)phenyl] sulfone and a tetracarboxylic acid dianhydride having the formula (I):

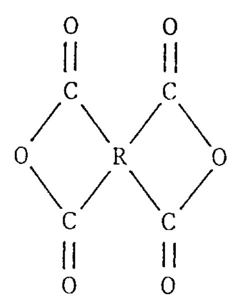

(I)

(where (R) is the same as before)
and which have recurring units of the formula (IX):

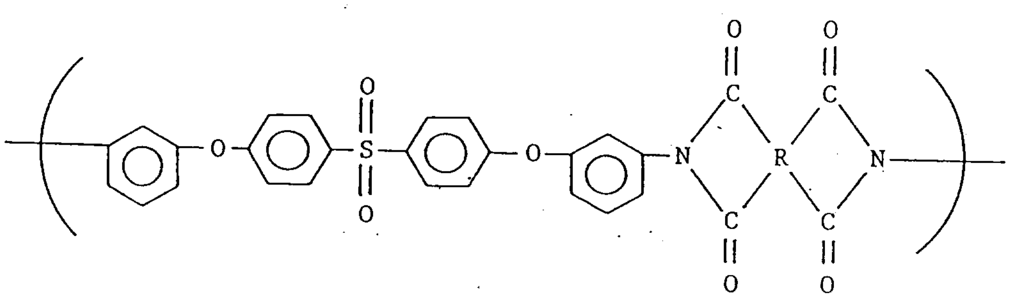

(IX)

(where R is the same as before).

(7) Polyimides which are derived from 1,3-bis(3-aminophenoxy)benzene and a tetracarboxylic acid dianhydride having the formula (I):

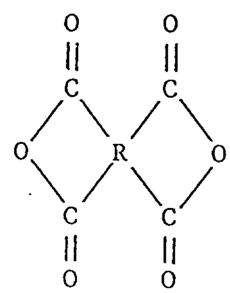

(I)

(where R is the same as before)
and which have recurring units of the formula (X):

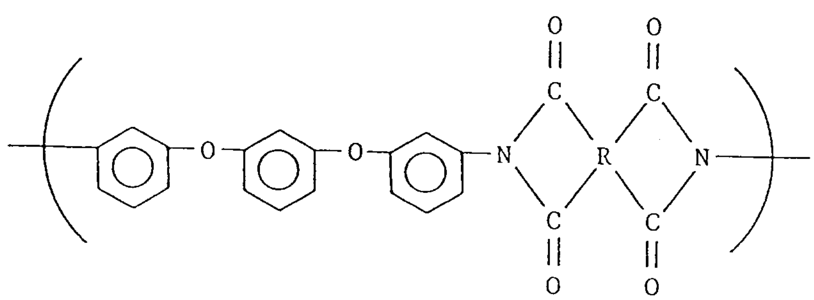

(X)

(where R is the same as before).

The adhesion between the high temperature flowable polyimide and the copper foil is achieved by use of (1) the polyimide itself or (2) the polyamic acid precursor of the polyimide.

(1) When the polyimide itself is used, the polyamic acid is thermally or chemically dehydrated in advance to obtain the polyimide in the form of film or powder. Polyimide film can also be made by calender rolling the powder. The film or powder is put on the copper foil, pressed at 50 to 400 ° C under a pressure of 1 to 1,000 kg/cm$^2$ and cured at 100 to 400 ° C to give the flexible copper-clad circuit substrate.

(2) When the polyamic acid precursor of the polyimide is used, a polyamic acid solution is applied on the copper foil and heated at 100 to 400 ° C, preferably at 200 to 300 ° C, to remove the solvents and convert the polyamic acid to the more stable polyimide.

The polyamic acid solution is required to have optimum viscosity so that the desired thickness of the coated film can be obtained by this application method. The viscosity should be 1,000 to 300,000 centipoises and the concentration can also be adjusted by the choice of organic solvent. The coating should be as uniform as possible and can be performed with a bar coater or doctor blade.

In the thermal conversion of the polyamic acid to polyimide, it is preferred to heat under a pressure of 1 to 1,000 kg/cm$^2$ and preferably 1 to 50 kg/cm$^2$. The peel strength of the united copper foil and polymer film can be further reinforced by increasing the pressure.

Since the polyimide layer of the flexible copper-clad circuit substrate of this invention is flowable at high temperatures, these substrates are also characterized by the ability to hot-bond with other metal substrates.

## SPECIFIC EXAMPLES

The invention will now be illustrated further by the following detailed examples. Examples 1 and 2 are presented not as embodiments of the invention, but as examples which are useful for understanding the invention. Inherent viscosity in these Examples was measured at 35°C in 0.5 g/100 ml, N,N-dimethylacetamide solution. Rotational viscosity was measured at 25°C with a high viscosity rotor of a model B viscometer.

Melt viscosity was measured at various temperatures and pressures with a nozzle of 0.1 cm in diameter and 1 cm in length, by use of the Society of Polymer Science Model flow tester (Shimadzu Seisakusho CFT-500).

In addition, the peel strength of the copper foil on the copper-clad circuit substrate was measured in accordance with JIS C-6481.

### Example 1

In a reaction vessel with a stirrer, reflux condenser and nitrogen inlet tube, 53.0 grams (0.25 mol) of 3,3'-diaminobenzophenone was dissolved into 240 ml of N,N-dimethylacetamide. The resultant solution had added to it 78.6 grams (0.244 mol) of 3,3'4,4'-benzophenone tetracarboxylic dianhydride powder and the mixture was stirred at 10°C for 24 hours. The polyamic acid thus obtained had an inherent viscosity of 0.59 dl/g and a rotational viscosity of 32,000 cps. The solution was uniformly coated on to an electrolytic copper foil of 35 µm thickness using a doctor blade.

The coated copper foil was heated for an hour each at 100°C, 200°C and 300°C to give the copper-clad circuit substrate. The thickness of the coated film was about 50 µm. The peel strength of the copper foil of the copper-clad circuit substrate was 3.5 kg/cm at room temperature (25°C). The same value was obtained after solder heat resistance tests for 180 seconds at 180°C and 300°C.

In addition, a part of the polyamic acid solution was heated at 100°C to give polyimide powder having a melt viscosity of 2,900 poises at 330°C and a shear rate of $10^3$ 1/second.

### Example 2

An electrolytic copper foil of 35 µm thickness was put on a steel drum for continuous film casting and polyamic acid solution obtained in Example 1 was applied thereon using a doctor blade. The steel drum was gradually heated from 100°C to 250°C and finally the foil was pressed through rolls at 300°C to give the copper-clad circuit substrate in a continuous operation. The thickness of the coated film was about 55 µm. The peel strength of the copper foil of the substrate was 3.7 kg/cm at room temperature (25°C). The same value was obtained after solder heat resistance tests for 180 seconds at 260°C and 300°C.

### Example 3

A reaction vessel with a stirrer, reflux condenser and nitrogen inlet tube was charged with 41.0 grams (0.1 mol) of 2,2-bis[4-(3-aminophenoxy)phenyl]propane and 200 ml of N,N-dimethylacetamide and cooled to about 0°C. Under a nitrogen atmosphere 21.8 grams (0.1 mol) of pyromellitic dianhydride powder were added and the mixture stirred for 2 hours at about 0°C. The temperature of the reaction mixture was raised to room temperature and stirred for about 20 hours under a nitrogen atmosphere. The polyamic acid solution thus obtained had an inherent viscosity of 1.5 dl/g and a rotational viscosity of 56,000 cps.

The solution was applied to an electrolytic copper foil of 35 µm thickness. The coated copper foil was heated for an hour each at 100°C, 200°C and 300°C to give the copper-clad circuit substrate. The thickness of the coated film was 125 µm. The peel strength of the copper foil was 3.8 kg/cm at room temperature (25°C). The same value was obtained after solder heat resistance tests for 180 seconds at 180°C and 300°C.

In addition, the polyimide powder obtained by the same procedure as Example 1 had a melt viscosity of 4,900 poises at 380°C and a shear rate of $10^3$ 1/second.

Example 4

A reaction vessel with a stirrer, reflux condenser and nitrogen inlet tube was charged with 41.0 grams (0.1 mol) of 2,2-bis[4-(3-aminophenoxy)phenyl]propane and 219.6 grams of N,N-dimethylacetamide. Under a nitrogen atmosphere and at room temperature, 31.6 grams (0.098 mol) of 3,3',4,4'-benzophenone tetracarboxylic dianhydride was added as dry solids a small portion at a time, with care taken to avoid temperature rise of the solution, and the mixture allowed to react for 23 hours at room temperature. The resultant polyamic acid had an inherent viscosity of 0.70 dl/g.

The polyamic acid solution was diluted with 266 grams of N,N-dimethylacetamide to give a rotational viscosity of 35,600 cps.

The solution thus obtained was applied on an electrolytic copper foil as in Example 1 to give a copper-clad circuit substrate having a film thickness of 35 µm. The peel strength of the copper foil was 3.6 kg/cm at room temperature (25 °C). The same value was obtained after solder heat resistance tests for 180 seconds at 260 °C and 300 °C.

Comparative Example 1

The procedure of Example 4 was repeated except 2,2-bis-[4-(4-aminophenoxy)phenyl]propane was used in place of 2,2-bis-[4-(3-aminophenoxy)phenyl]propane to give polyamic acid having an inherent viscosity of 1.16 dl/g.

The polyimide powder prepared from the polyamic acid did not flow even at 400 °C under a load of 500 kg.

The polyamic acid solution was diluted with 368 grams of N,N-dimethylacetamide to give a rotational viscosity of 34,200 cps. A copper-clad circuit substrate having a film thickness of 34 µm was obtained by the same procedure as in Example 1. The peel strength of the copper-foil had the poor value of 0.7 kg/cm at room temperature (25 °C).

Examples 5-21 and Comparative Example 2

The procedure of Example 1 was repeated except the type and quantity of the diamine, the quantity of N,N-dimethylacetamide, and the type and quantity of the tetracarboxylic acid dianhydride were changed to give the results set out in Tables 1 and 2 .

Regarding the quantities of N,N-dimethylacetamide in Table 1, the first figures indicate the quantity used for polymerization and the figures in parentheses indicate any further quantity added after polymerization to dilute the solution. In the cases where there was dilution after polymerization the rotational viscosities were measured after dilution. Melt viscosity was measured at a shear rate of $10^3$ 1/second.

In Table 1, PMDA means pyromellitic dianhydride, BTDA means 3,3',4,4'-benzophenone tetracarboxylic dianhydride, ODPA means bis(3,4-dicarboxyphenyl) ether dianhydride and BPDA means 3,3',4,4'-biphenyl tetracarboxylic dianhydride.

Example 22

The polyamic acid solution obtained in Example 5 was cast on a glass plate and heated for an hour each at 100 °C, 200 °C and 300 °C to give a light yellow transparent polyimide film having a thickness of 30 µm. The polyimide film had a tensile strength of 13.5 kg/mm$^2$ and an elongation of 42% in accordance with ASTM D-882. The film also had a glass transition temperature of 225 °C in accordance with the TMA penetration method and a 5% weight decrease temperature in air of 542 °C in accordance with the DTA-TG method.

The polyimide film was put on an electrolytic copper foil of 35 µm thickness and was hot-pressed at 270 °C for 10 minutes under a pressure of 20 kg/cm$^2$ to give a flexible copper-clad circuit substrate. The peel strength of the copper foil was 2.7 kg/cm at room temperature (25 °C). The same value was obtained after solder heat resistance tests for 180 seconds at 260 °C and 300 °C.

Table 1 Materials and Solvent

| No. | Diamine (g) | Diamine (mol) | Dianhydride (g) (mol) | Solvent (N,N-Dimethyl-acetamide) (g) |
|---|---|---|---|---|
| Example -5 | bis[4-(3-aminophenoxy)phenyl] sulfide 40 | (0.1) | PMDA 21.1 (0.097) | 184.5 |
| Example -6 | bis[4-(3-aminophenoxy)phenyl] sulfide 40 | (0.1) | BTDA 31.6 (0.098) | 214.8 |
| Example -7 | bis[4-(3-aminophenoxy)phenyl] sulfide 40 | (0.1) | ODPA 36.6 (0.0986) | 184.5 |
| Example -8 | bis[4-(3-aminophenoxy)phenyl] sulfide 40 | (0.1) | BPDA 28.3 (0.0965) | 205 |
| Example -9 | 4,4'-bis(3-aminophenoxy)biphenyl 36.8 | (0.1) | PMDA 20.71 (0.095) | 175.8 |
| Example -10 | 4,4'-bis(3-aminophenoxy)biphenyl 18.4 | (0.05) | BTDA 16.1 (0.05) | 103.5 (473) |
| Example -11 | 4,4'-bis(3-aminophenoxy)biphenyl 9.2 | (0.025) | ODPA 7.75 (0.025) | 50.85 (271) |
| Example -12 | 4,4'-bis(3-aminophenoxy)biphenyl 9.2 | (0.025) | BPDA 7.06 (0.024) | 48.8 (206) |
| Example -13 | bis[4-(3-aminophenoxy)phenyl] ketone 39.6 | (0.1) | PMDA 21.36 (0.098) | 182.9 |
| Example -14 | bis[4-(3-aminophenoxy)phenyl] ketone 39.6 | (0.1) | PMDA 21.36 (0.098) | 182.9 |

Table 1 (continued)

| No. | Diamine (g) | Diamine (mol) | Dianhydride (g) (mol) | Solvent (N,N-Dimethyl-acetamide) (g) |
|---|---|---|---|---|
| Example -15 | bis[4-(3-aminophenoxy)phenyl] ketone 39.6 | (0.1) | BTDA 31.5 (0.098) | 215.4 |
| Example -16 | bis[4-(3-aminophenoxy)phenyl] ketone 39.6 | (0.1) | ODPA 30.5 (0.099) | 210 |
| Example -17 | bis[4-(3-aminophenoxy)phenyl] sulfone 43.2 | (0.1) | PMDA 21.8 (0.1) | 195 (823) |
| Example -18 | bis[4-(3-aminophenoxy)phenyl] sulfone 43.2 | (0.1) | BPDA 28.4 (0.0965) | 167 |
| Example -19 | 2,2-bis[4-(3-aminophenoxy)phenyl]-1,1,1,3,3,3-hexafluoropropane 10.36 | (0.02) | PMDA 4.273 (0.0196) | 44.16 |
| Example -20 | 2,2-bis[4-(3-aminophenoxy)phenyl]-1,1,1,3,3,3-hexafluoropropane 5.18 | (0.01) | BTDA 3.19 (0.0099) | 25.2 (8.3) |
| Example -21 | 2,2-bis[4-(3-aminophenoxy)phenyl]-1,1,1,3,3,3-hexafluoropropane 5.18 | (0.01) | ODPA 3.01 (0.0097) | 24.6 |
| Comparat. Example -2 | 4,4'-diaminodiphenylether 20.0 | (0.1) | PMDA 21.8 (0.1) | 125.4 (529) |

Table 2 Properties of Polyamic Acid and Polyimide

| No. | Viscosity inherent (dl/g) | Viscosity rotational (cps) | Viscosity melt (poise) (°C) | Copper foil and thickness ( μm) | Film thickness ( μm) | Peel strength (kg/cm) room 25°C | Peel strength (kg/cm) solder 260°C 180 sec | Peel strength (kg/cm) solder 300°C 180 sec |
|---|---|---|---|---|---|---|---|---|
| Example -5 | 1.0 | 34,000 | 5,200 (340) | electrolytic (35) | 30 | 2.6 | 2.6 | 2.6 |
| Example -6 | 1.2 | 67,000 | | " | 32 | 2.7 | 2.7 | 2.6 |
| Example -7 | 1.1 | 48,500 | | " | 33 | 2.9 | 2.9 | 2.9 |
| Example -8 | 0.6 | 2,000 | | " | 30 | 2.9 | 2.9 | 2.9 |
| Example -9 | 0.60 | 2,100 | 4,700 (400) | " | 35 | 3.0 | 3.0 | 3.0 |
| Example -10 | 1.62 | 10,000 | | " | 34 | 2.8 | 2.8 | 2.8 |
| Example -11 | 1.70 | 8,500 | | " | 35 | 2.9 | 2.7 | 2.7 |
| Example -12 | 1.8 | 12,000 | | " | 37 | 2.8 | 2.8 | 2.8 |
| Example -13 | 0.85 | 8,000 | | rolled (35) | 30 | 2.4 | 2.4 | 2.4 |
| Example -14 | 0.85 | 8,000 | | electrolytic (35) | 30 | 2.9 | 2.9 | 2.9 |

Table 2 (continued)

| No. | Viscosity inherent (dl/g) | Viscosity rotational (cps) | Viscosity melt (poise) (°C) | Copper foil and thickness (μm) | Film thickness (μm) | Peel strength (kg/cm) room 25°C | Peel strength (kg/cm) solder 260°C 180 sec | Peel strength (kg/cm) solder 300°C 180 sec |
|---|---|---|---|---|---|---|---|---|
| Example -15 | 0.78 | 5,000 | 4,800 (360) | electrolytic (35) | 35 | 2.8 | 2.8 | 2.8 |
| Example -16 | 0.8 | 5,800 | | " | 30 | 2.8 | 2.8 | 2.8 |
| Example -17 | 1.6 | 5,000 | | " | 30 | 2.2 | 2.2 | 2.2 |
| Example -18 | 0.62 | 8,500 | | " | 28 | 2.7 | 2.7 | 2.7 |
| Example -19 | 0.55 | 1,400 | 3,500 (400) | " | 80 | 2.7 | 2.7 | 2.7 |
| Example -20 | 1.1 | 25,000 | | " | 35 | 2.8 | 2.8 | 2.8 |
| Example -21 | 0.68 | 3,800 | | " | 35 | 2.8 | 2.8 | 2.8 |
| Comparat. Example -2 | 1.5 | 9,000 | | " | 30 | 0.5 | 0.5 | 0.5 |

## Claims

1. A flexible copper-clad circuit substrate which comprises a high-temperature flowable polyimide film faced with copper foil bonded directly thereto, without adhesive in between, wherein the polyimide film essentially consists of a polyimide having recurring units of the formula:

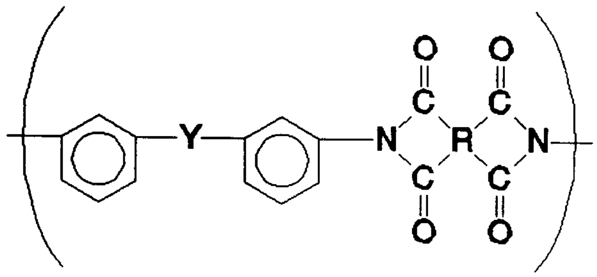

where R represents an aliphatic radical having 2 or more carbons, a cycloaliphatic radical, a monocyclic aromatic radical, a condensed polyaromatic radical, or a non-condensed polyaromatic radical in which the aromatic rings are connected directly or by a bridging member, and Y represents:

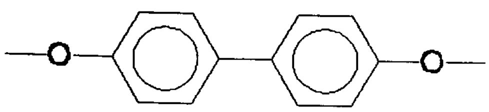

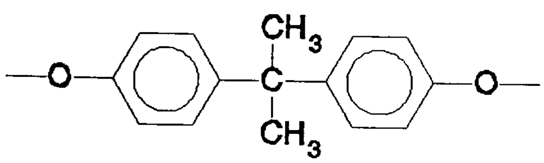

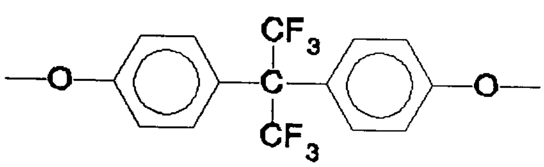

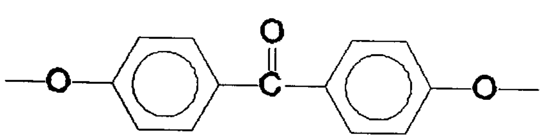

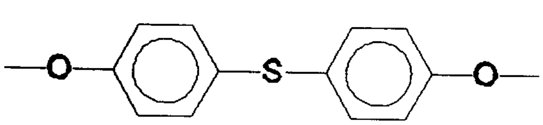

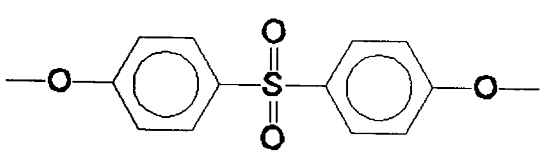

or

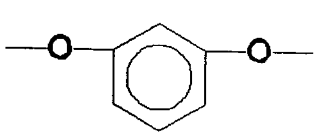

**2.** A process for making a flexible copper-clad circuit substrate which comprises a high-temperature flowable polyimide film faced with copper foil bonded directly thereto, without adhesive in between, wherein the polyimide film essentially consists of a polyimide having recurring units of the formula:

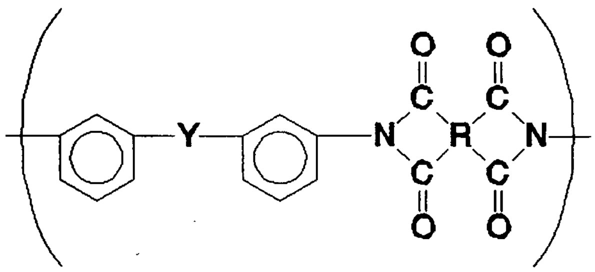

where R represents an aliphatic radical having 2 or more carbons, a cycloaliphatic radical, a monocyclic aromatic radical, a condensed polyaromatic radical, or a non-condensed polyaromatic radical in which the aromatic rings are connected directly or by a bridging member, and Y represents:

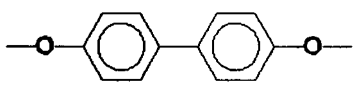

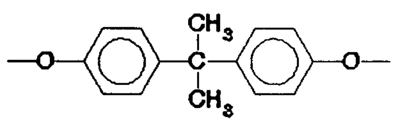

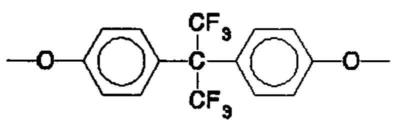

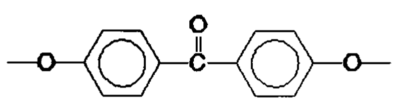

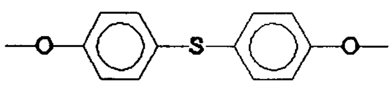

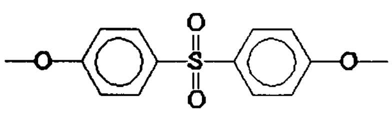 or

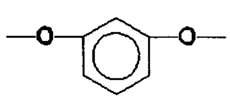 ,

and in that a film or powder of the polyimide is placed on the copper foil, the film or powder is pressed at 50 to 400 °C under a pressure of 1 to 1,000kg/cm$^2$ and the resulting pressed film is curing at a temperature of 100 to 400 °C.

**3.** A process for making a flexible copper-clad circuit substrate which comprises a high-temperature flowable polyimide film faced with copper foil bonded directly thereto, without adhesive in between, wherein the polyimide film essentially consists of a polyimide having recurring units of the formula:

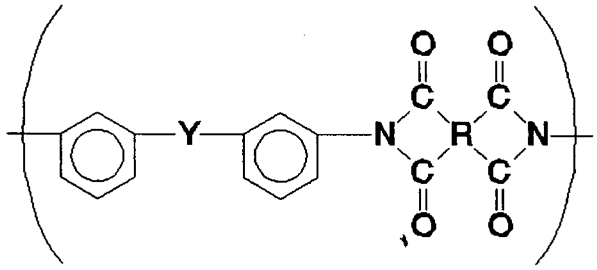

where R represents an aliphatic radical having 2 or more carbons, a cycloaliphatic radical, a monocyclic aromatic radical, a condensed polyaromatic radical, or a non-condensed polyaromatic radical in which the aromatic rings are connected directly or by a bridging member, and Y represents:

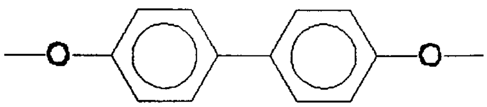

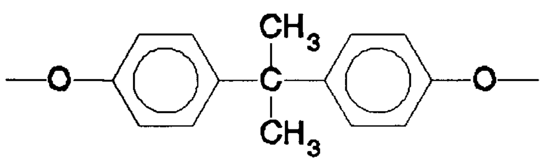

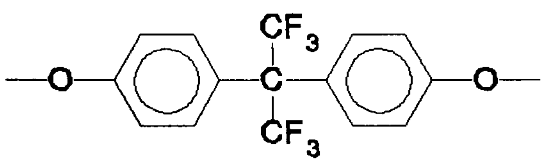

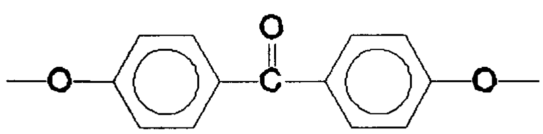

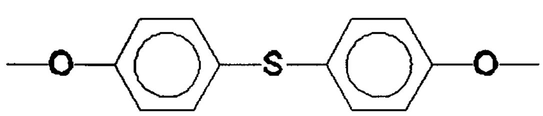

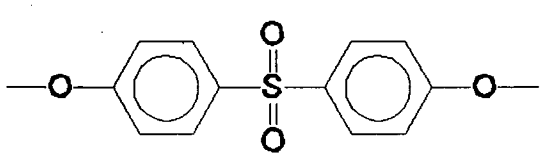

or

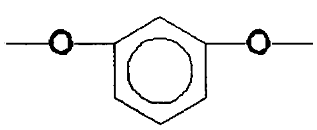

,

and in that a solution of the polyamic acid precursor for the said polyimide is placed on the copper foil,

the polyamic acid solution having a viscosity of 1,000 to 300,000 centipoises, and heating the polyamic acid solution at 100 to 400 °C to remove the solvent and convert the polyamic acid to the said polyimide.

## Patentansprüche

1. Flexibles kupferplattiertes Schaltungs-Substrat, welches einen fließfähigen Hochtemperaturpolyimidfilm umfaßt, der mit Kupferfolie verkleidet ist, die unmittelbar mit diesem verbunden ist, und zwar ohne Zwischenfügung von Haftmittel, worin der Polyimidfilm im wesentlichen aus einem Polyimid mit rekurrenten Einheiten folgender Formel besteht :

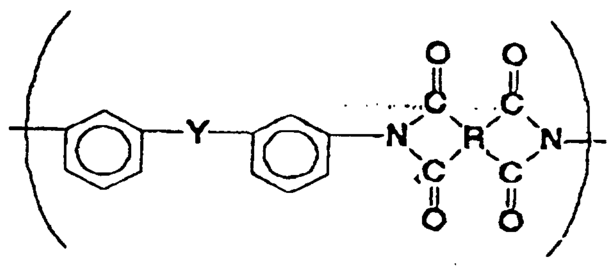

worin R ein aliphatisches Radikal mit mindestens zwei Kohlenstoffen, ein cycloaliphatisches Radikal, ein monocyclisches aromatisches Radikal, ein kondensiertes polyaromatisches Radikal oder ein nichtkondensiertes polyaromatisches Radikal ist, in dem die aromatischen Ringe durch eine direkte Bindung oder durch eine Brückenbindung miteinander verbunden sind, und Y folgendes darstellt :

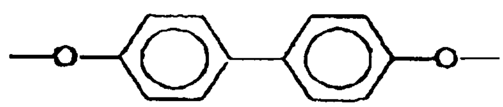

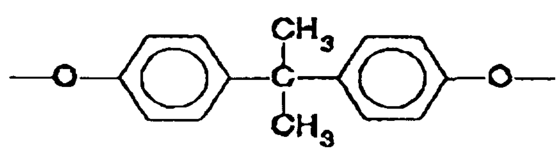

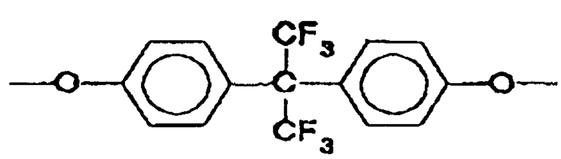

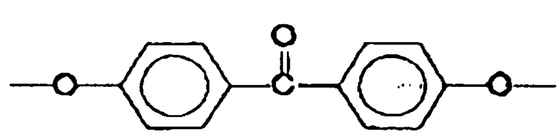

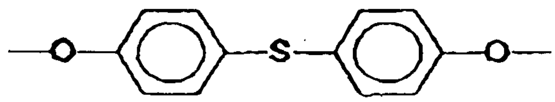

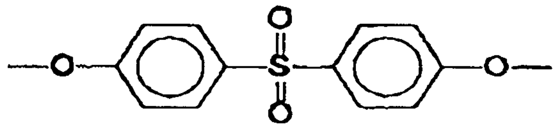

oder

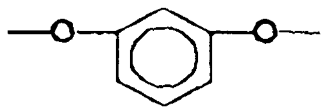

2. Verfahren zur Herstellung eines flexiblen kupferplattierten Schaltungs-Substrats, welches einen fließfähigen Hochtemperaturpolyimidfilm umfaßt, der mit Kupferfolie verkleidet ist, die unmittelbar, ohne Zwischenfügung eines Haftmittels, mit diesem verbunden ist, worin der Polyimidfilm im wesentlichen aus einem Polyimid mit rekurrenten Einheiten folgender Formel besteht :

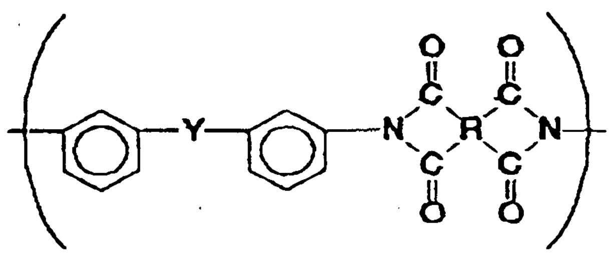

worin R ein aliphatisches Radikal mit mindestens zwei Kohlenstoffen, ein cycloaliphatisches Radikal, ein monocyclisches aromatisches Radikal, ein kondensiertes polyaromatisches Radikal oder ein nichtkondensiertes polyaromatisches Radikal ist, in dem die aromatischen Ringe entweder durch eine direkte Bindung oder durch eine Brückenbindung miteinander verbunden sind, und Y folgendes darstellt :

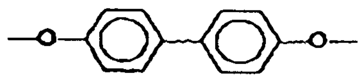

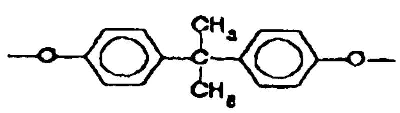

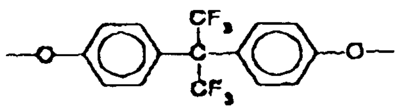

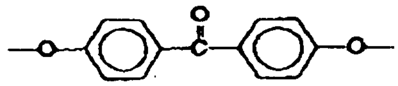

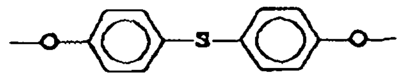

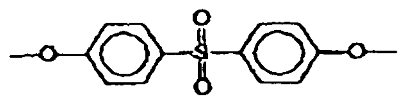

oder

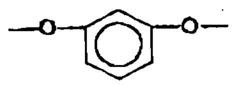

und worin ein Film oder Pulver des Polyimids auf die Kupferfolie aufgebracht wird, wobei der Film oder das Pulver bei 50° bis 400° C bei einem Druck von 1 bis 1.000 kg/cm$^2$ gepresst wird und der gewonnene gepresste Film bei einer Temperatur von 100° bis 400° C gehärtet wird.

**3.** Verfahren zur Herstellung eines flexiblen kupferplattierten Schaltungs-Substrats, welches einen fließfähigen Hochtemperaturpolyimidfilm umfaßt, der mit Kupferfolie verkleidet ist, die unmittelbar mit diesem verbunden ist, und zwar ohne Zwischenfügung von Haftmittel,
worin der Polyimidfilm im wesentlichen aus Polyimid mit rekurrenten Einheiten folgender Formel besteht :

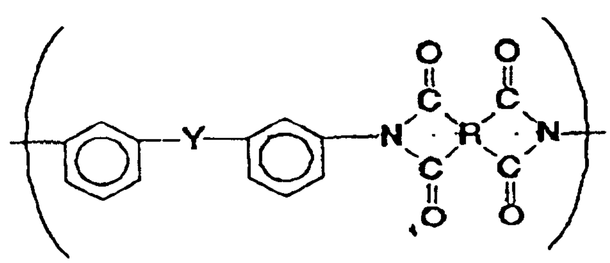

worin R ein aliphatisches Radikal mit mindestens zwei Kohlenstoffen, ein cycloaliphatisches Radikal, ein monocyclisches aromatisches Radikal, ein kondensiertes polyaromatisches Radikal oder ein nichtkondensiertes polyaromatisches Radikal ist, in dem die aromatischen Ringe entweder durch eine direkte Bindung oder durch eine Brückenbindung miteinander verbunden sind, und Y folgendes darstellt :

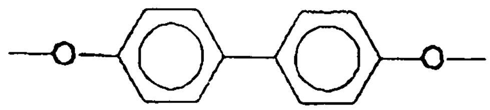

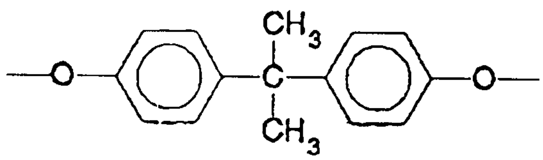

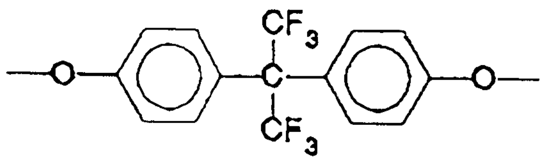

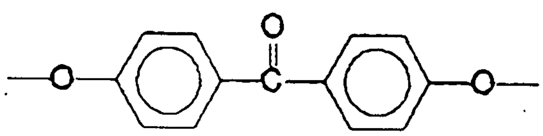

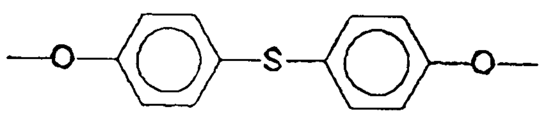

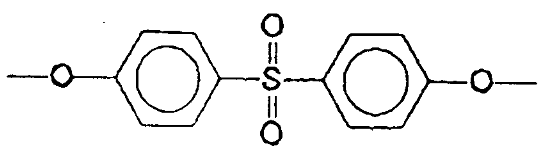

oder

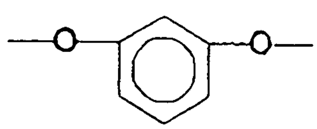

,

und worin eine Lösung der Polyamidsäurevorstufe für dieses Polyimid auf die Kupferfolie aufgebracht wird, wobei die Polyamidsäurelösung eine Viskosität von 1.000 bis 300.000 Zentipoise besitzt, und die Polyamidsäurelösung bei 100° bis 400° C erhitzt wird, um das Lösemittel zu entfernen und die Polyamidsäure in dieses Polyimid umzuwandeln.

## Revendications

1. Substrat souple cuivré pour circuits imprimés qui comprend un film de polyimide pouvant fluer à température élevée et recouvert d'une feuille de cuivre qui lui est reliée directement, sans adhésif entre eux, dans lequel le film de polyimide consiste essentiellement en un polyimide présentant des unités récurrentes de la formule:

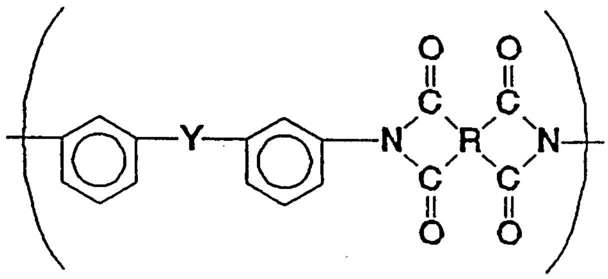

où R représente un radical aliphatique comportant deux ou plusieurs atomes de carbone, un radical cycloaliphatique, un radicalaromatique monocyclique, un radical polyaromatique condensé, ou un radical polyaromatique non condensé dans lequel les cycles aromatiques sont reliés directement ou par l'intermédiaire d'un élément formant pont, et Y représente:

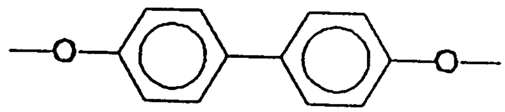

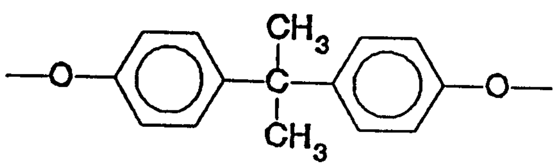

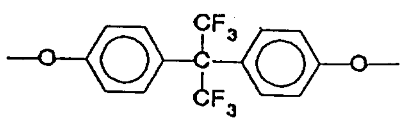

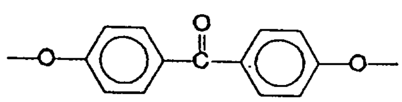

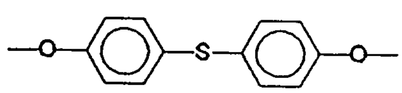

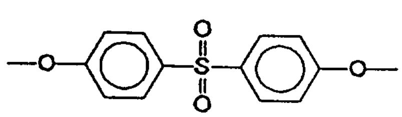

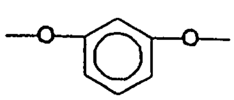

**2.** Procédé pour réaliser un substrat souple cuivré pour circuits imprimés qui comprend un film de polyimide pouvant fluer à haute température et recouvert d'une feuille de cuivre qui est liée sur lui directement sans adhésif, dans lequel le film de polyimide consiste essentiellement en un polyimide comprenant des unités récurrentes de la formule:

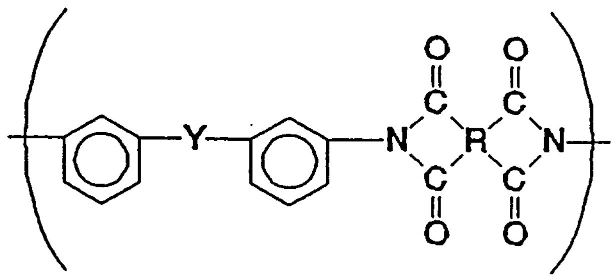

où R représente un radical aliphatique comportant deux ou plusieurs atomes de carbone, un radical cycloaliphatique, un radicalaromatique monocyclique, un radical polyaromatique condensé, ou un radical polyaromatique non condensé dans lequel les cycles aromatiques sont reliés directement ou par l'intermédiaire d'un élément formant pont, et Y représente:

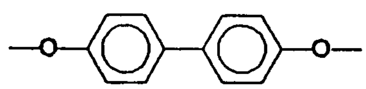

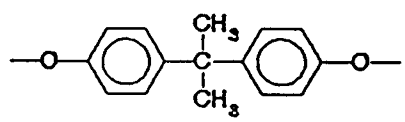

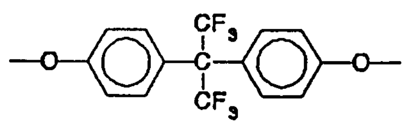

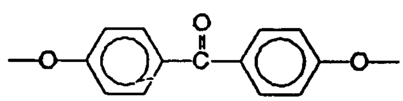

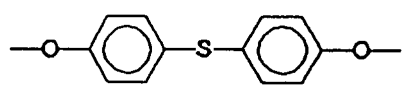

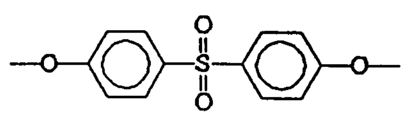

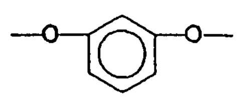

et en ce qu'un film ou une poudre du polyimide est placé sur la feuille de cuivre, le film ou la poudre est pressé entre 50 et 400 ° C sous une pression de 1 à 1000 kg/cm$^2$ et le film pressé résultant est polymérisé à une température de 100 à 400 ° C.

**3.** Procédé pour réaliser un substrat souple cuivré pour circuits imprimés qui comprend un film de polyimide pouvant fluer à haute température et recouvert d'une feuille de cuivre qui est liée sur lui directement sans adhésif, dans lequel le film de polyimide consiste essentiellement en un polyimide comprenant des unités récurrentes de la formule:

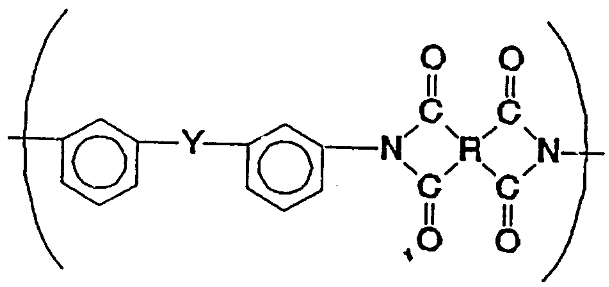

où R représente un radical aliphatique comportant deux ou plusieurs atomes de carbone, un radical cycloaliphatique, un radicalaromatique monocyclique, un radical polyaromatique condensé, ou un radical polyaromatique non condensé dans lequel les cycles aromatiques sont reliés directement ou par l'intermédiaire d'un élément formant pont, et Y représente:

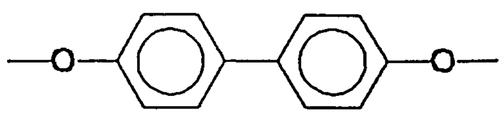

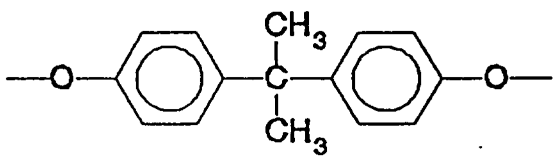

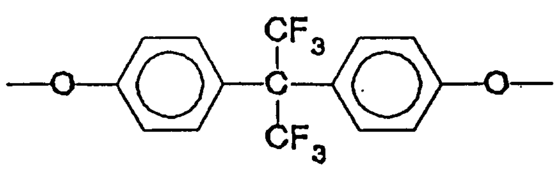

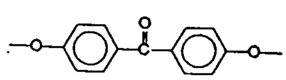

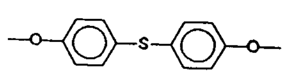

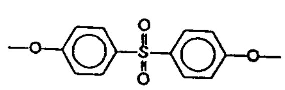

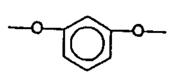

et en ce qu'une solution du précurseur de l'acide polyamique pour ledit polyimide est placé sur la feuille de cuivre, la solution d'acide polyamique présentant une viscosité de 1 à 300 Pa.s, et on chauffe la solution d'acide polyamique entre 100 et 400 °C pour éliminer le solvant et convertir l'acide polyamique en ledit polyimide.